# EUROPÄISCHE PATENTANMELDUNG

(11) **EP 4 450 835 A1**
(43) Veröffentlichungstag der Anmeldung: **23.10.2024**
(21) Anmeldenummer: 23168241.0
(22) Anmeldetag: 17.04.2023
(51) Int. Cl.: F16B 5/06

(54) **ERZEUGNIS MIT AUTOMATISIERT MONTIERBAREN TEILEN**

(71) Anmelder: Siemens Aktiengesellschaft, 80333 München (DE)
(72) Erfinder: Dathe, Alexander, 09221 Neukirchen (DE); Mehlich, Jan, 09126 Chemnitz (DE)
(74) Vertreter: Siemens Patent Attorneys

(57) **Zusammenfassung**

Ein Erzeugnis weist ein erstes und ein zweites Teil (1, 2) auf, die durch Verrasten miteinander verbunden sind. Das erste Teil (1) weist einen ersten Basiskörper (4) auf, von dem ausgehend sich eine Anzahl von Vorsprüngen (5) erstreckt, so dass die Vorsprünge (5) eine Einführrichtung (x) definieren. Das zweite Teil (2) weist einen zweiten Basiskörper (6) auf, in dem eine Anzahl von Aufnahmen (7) angeordnet ist. Wenn das erste Teil (1) mit dem zweiten Teil (2) verrastet ist, ist je einer der Vorsprünge (5) des ersten Teils (1) in der Einführrichtung (x) in je eine der Aufnahmen (7) des zweiten Teils (2) eingeführt. An den Vorsprüngen (5) sind Rasthaken (11) angeordnet, am zweiten Teil (2) im Bereich der Aufnahmen (7) Rastnasen (12). Wenn die Vorsprünge (5) vollständig in die Aufnahmen (7) eingeführt sind, bilden die Rasthaken (11) und die Rastnasen (12) jeweils eine Rastverbindung. Die Vorsprünge (5) und die Aufnahmen (7) sind derart aufeinander abgestimmt, dass die Vorsprünge (5) zu Beginn des Einführens der Vorsprünge (5) in die Aufnahmen (7) in den Aufnahmen (7) in einer orthogonal zur Einführrichtung (x) verlaufenden Querebene gesehen in zwei zueinander orthogonalen Querrichtungen (y, z) ein Spiel aufweisen. Das Spiel nimmt beim Einführen der Vorsprünge (5) in die Aufnahmen (7), ausgehend von einem Anfangswert größer als Null, allmählich auf Null ab.

## Beschreibung

Die vorliegende Erfindung geht aus von einem (mehrteiligen) Erzeugnis,
- wobei das Erzeugnis ein erstes und ein zweites Teil aufweist, die durch Verrasten miteinander verbunden sind,
- wobei das erste Teil einen ersten Basiskörper aufweist, von dem ausgehend sich eine Anzahl von Vorsprüngen erstreckt, so dass die Vorsprünge eine Einführrichtung definieren,
- wobei das zweite Teil einen zweiten Basiskörper aufweist, in dem eine Anzahl von Aufnahmen angeordnet ist,
- wobei, wenn das erste Teil mit dem zweiten Teil verrastet ist, je einer der Vorsprünge des ersten Teils in der Einführrichtung in je eine der Aufnahmen des zweiten Teils eingeführt ist,
- wobei an den Vorsprüngen Rasthaken angeordnet sind und am zweiten Teil im Bereich der Aufnahmen Rastnasen angeordnet sind,
- wobei, wenn die Vorsprünge vollständig in die Aufnahmen eingeführt sind, die Rasthaken und die Rastnasen jeweils eine Rastverbindung bilden.

Die Einführrichtung ist eine vorzeichenbehaftete Richtung. Das Einführen der Vorsprünge in die Aufnahmen erfolgt in der Einführrichtung, ein etwaiges Lösen der Vorsprünge aus den Aufnahmen entgegen der Einführrichtung.

Derartige Erzeugnisse sind allgemein bekannt.

In der Fertigungstechnik besteht mehr und mehr das Bestreben, Montagevorgänge automatisiert auszuführen, beispielsweise durch Roboter. Für eine automatisierte Montage muss dem Fügen der Teile eine besondere Aufmerksamkeit gewidmet werden. Insbesondere bei filigranen Montagetätigkeiten ist der Mensch dem Automaten normalerweise überlegen. Denn ein Mensch kann die exakte Positionierung aufgrund optischer Wahrnehmung und manchmal aufgrund von Fingerspitzengefühl gut vornehmen. Die Maschine hingegen, sei es ein Roboter oder eine andere Maschine, führt lediglich ihre vorprogrammierten Bewegungen aus, wobei die Maschine nicht detektieren kann, ob das erste Teil und/oder das zweite Teil an der exakt richtigen Position angeordnet sind. Es ist daher erforderlich, die Teile des Erzeugnisses derart auszulegen, dass sich die Einzelteile des Erzeugnisses beim Fügen mit Hilfe von Führungen, Einführschrägen und anderen Positionierhilfen selbsttätig zentrieren.

Die Aufgabe der vorliegenden Erfindung besteht darin, Möglichkeiten zu schaffen, mittels derer eine derartige selbsttätige Zentrierung auf einfache Art und Weise mit einem Rastmechanismus kombiniert werden kann, dass also die jeweilige Positionierhilfe zugleich auch eine Rastverbindung bewirkt.

Die Aufgabe wird durch ein Erzeugnis mit den Merkmalen des Anspruchs 1 gelöst. Vorteilhafte Ausgestaltungen des Erzeugnisses sind Gegenstand der abhängigen Ansprüche 2 bis 7.

Erfindungsgemäß wird ein Erzeugnis der eingangs genannten Art dadurch ausgestaltet, dass die Vorsprünge und die Aufnahmen derart aufeinander abgestimmt sind, dass die Vorsprünge zu Beginn des Einführens der Vorsprünge in die Aufnahmen in den Aufnahmen in einer orthogonal zur Einführrichtung verlaufenden Querebene gesehen sowohl in einer ersten Querrichtung als auch in einer zur ersten Querrichtung orthogonalen zweiten Querrichtung ein Spiel aufweisen, das beim Einführen der Vorsprünge in die Aufnahmen, ausgehend von einem Anfangswert größer als Null, allmählich auf Null abnimmt.

Die Rastverbindungen, die vom Ansatz her auch im Stand der Technik vorhanden sein können, werden also dahingehend ausgestaltet, dass sie zugleich auch die Führung, Positionierung und Zentrierung des ersten Teils relativ zum zweiten Teil vornehmen können.

Die Vorsprünge erstrecken sich in der Einführrichtung gesehen über eine Länge. Vorzugsweise sind die Vorsprünge und die Aufnahmen derart aufeinander abgestimmt, dass das Spiel beim Einführen der Vorsprünge in die Aufnahmen im wesentlichen über die gesamte Länge der Vorsprünge gleichzeitig den Wert Null annimmt. Durch diese Ausgestaltung liegen die Vorsprünge, wenn sie vollständig in die Aufnahmen eingeführt sind, großflächig an den Innenseiten der Aufnahmen an. Dadurch ergibt sich eine sehr stabile Befestigung des ersten Teils am zweiten Teil (oder umgekehrt).

Vorzugsweise weisen die Vorsprünge und die Aufnahmen in der Querebene gesehen die Kontur symmetrischer Trapeze mit einer jeweiligen langen Seite und einer jeweiligen kurzen Seite auf. Durch diese Ausgestaltung, also praktisch einen sich in der Einführrichtung gesehen verjüngenden Schwalbenschwanz, wird das Erfordernis der Zentrierung der Vorsprünge in den Aufnahmen in beiden Querrichtungen auf besonders einfache Art und Weise erreicht. Ohne Beschränkung der Allgemeinheit kann hierbei angenommen werden, dass die langen und die kurzen Seiten in der ersten Querrichtung verlaufen.

Vorzugsweise sind die Aufnahmen im Bereich der kurzen Seiten der Trapeze offen oder dünnwandiger als im Bereich der langen Seiten der Trapeze. Dadurch kann die Bauhöhe der Aufnahmen in der zweiten Querrichtung so gering wie möglich gehalten werden.

Vorzugsweise sind die Rasthaken im Bereich der langen Seiten der Trapeze angeordnet. Diese Lösung ist konstruktiv besonders einfach zu realisieren.

Vorzugsweise sind die Rasthaken, wenn das erste und das zweite Teil voneinander gelöst sind, innerhalb der durch die Trapeze umschriebenen Volumina angeordnet und sind weiterhin die Rastnasen federelastisch am zweiten Basiskörper angeordnet. Diese Maßnahme reduziert die Bauhöhe der Aufnahmen in der zweiten Querrichtung noch weiter.

Vorzugsweise weist das erste Teil in Übergangsbereichen von den Vorsprüngen zum ersten Basiskörper Mulden auf, über welche ein Biegen der Rasthaken und/oder der Rastnasen und dadurch ein Lösen der jeweiligen Rastverbindung möglich ist. Dadurch erleichtert sich das Lösen der Rastverbindungen. Beispielsweise kann mittels der Mulden auf einfache Weise ein Schraubendreher angesetzt werden.

Die oben beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung der Ausführungsbeispiele, die in Verbindung mit den Zeichnungen näher erläutert werden. Hierbei zeigen in schematischer Darstellung:
- FIG 1: eine perspektivische Ansicht einer elektronischen Baugruppe in einem montierten Zustand,
- FIG 2: die Baugruppe von FIG 1 vor dem Verbinden,
- FIG 3: die Baugruppe von FIG 1 von der Seite,
- FIG 4: einen Schnitt durch die Baugruppe von FIG 1 längs einer Linie A-A in FIG 3,
- FIG 5: einen Schnitt durch die Baugruppe von FIG 1 längs einer Linie B-B in FIG 3
- FIG 6: vergröbert und nicht maßstäblich eine Ansicht eines zweiten Basisteils aus der Richtung A-A in FIG 3 aus gesehen,
- FIG 7: ein erstes Basisteil und ein zweites Basisteil im Bereich eines Vorsprungs und einer Aufnahme aus einer ersten Querrichtung,
- FIG 8: das erste und das zweite Basisteil von FIG 7 aus der zweiten Querrichtung,
- FIG 9: eine Draufsicht auf das erste Basisteil von FIG 7 im Bereich eines Vorsprungs entgegen einer Einführrichtung,
- FIG 10: eine Draufsicht auf das zweite Basisteil von FIG 7 in der Einführrichtung,
- FIG 11: eine Modifikation des zweiten Basisteils von FIG 10,
- FIG 12: einen (gedanklich unendlich dünnen) Streifen des Vorsprungs des ersten Basisteils von FIG 7,
- FIG 13: einen Schnitt durch einen in einer Aufnahme angeordneten Vorsprung,
- FIG 14: eine perspektivische durchsichtige Darstellung eines ersten Basisteils und eines zweiten Basisteils im Bereich eines Vorsprungs und einer Aufnahme,
- FIG 15: ein Detail D gemäß FIG 5 und
- FIG 16: ein Detail E gemäß FIG 3.

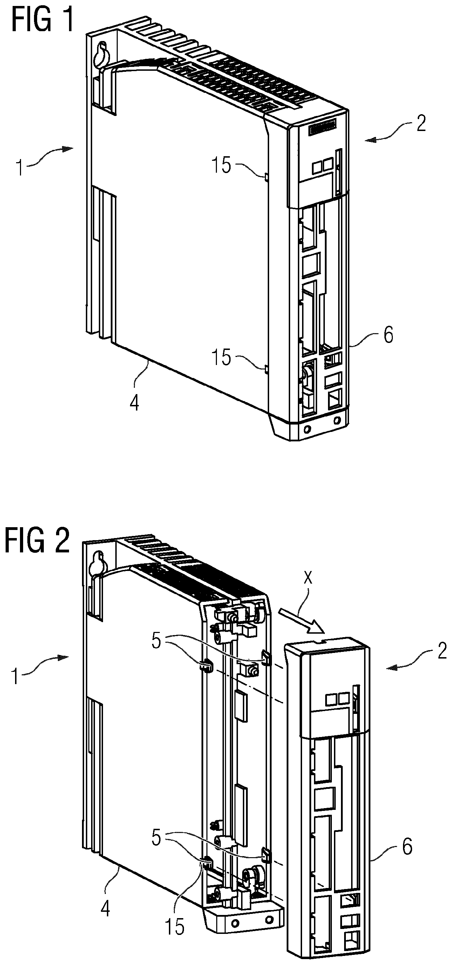

Die FIG 1 bis 5 zeigen verschiedene Darstellungen desselben Erzeugnisses. Die FIG 1 bis 5 werden daher nachstehend gemeinsam erläutert. Nur im Einzelfall wird auf eine einzelne der FIG 1 bis 5 verwiesen werden, wenn aus dieser FIG ein jeweiliges Detail besonders gut erkennbar ist.

In dem Beispiel der FIG 1 bis 5 ist das Erzeugnis als elektronische Baugruppe ausgebildet. Der Umstand, dass das Erzeugnis als elektronische Baugruppe ausgebildet ist, ist rein beispielhaft. Das Erzeugnis könnte auch anderweitig ausgebildet sein, beispielsweise rein mechanisch.

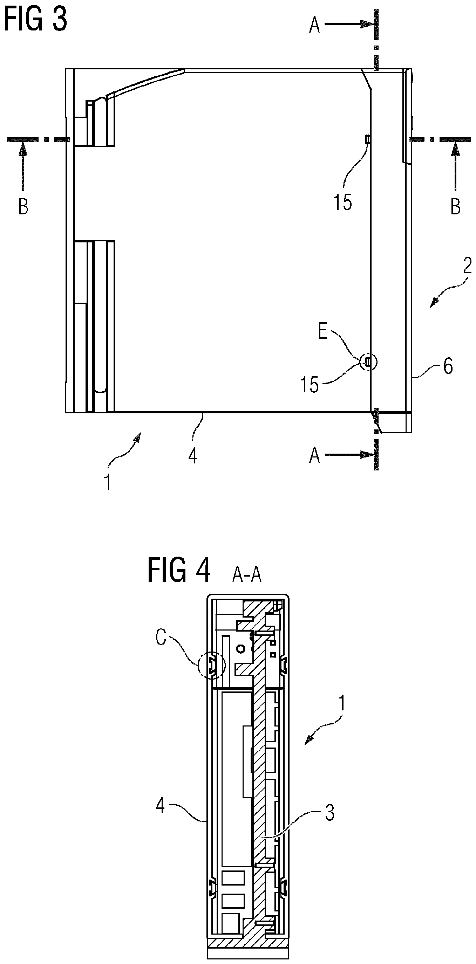

Gemäß den FIG 1 bis 5 weist das Erzeugnis ein erstes Teil 1 und ein zweites Teil 2 auf. Das erste Teil 1 ist vorliegend das Gehäuse der elektronischen Baugruppe, in dem ein Kühlkörper 3 (FIG 4) angeordnet ist, welcher der Kühlung elektronischer Leistungsbauelemente dient. Das zweite Teil 2 ist eine Frontabdeckung der elektronischen Baugruppe. Es könnte sich aber auch um andere Teile handeln. Weiterhin kann das Erzeugnis zusätzlich zu dem ersten Teil 1 und dem zweiten Teil 2 weitere Teile umfassen.

Das erste Teil 1 weist einen Basiskörper 4 auf, von dem ausgehend - siehe insbesondere FIG 2 - sich eine Anzahl von Vorsprüngen 5 erstreckt. Der Basiskörper 4 wird nachfolgend als erster Basiskörper 4 bezeichnet. Die Vorsprünge 5 definieren dadurch eine Einführrichtung x. Die Einführrichtung x ist diejenige Richtung, in welcher sich die Vorsprünge 5 von dem ersten Basiskörper 4 weg erstrecken.

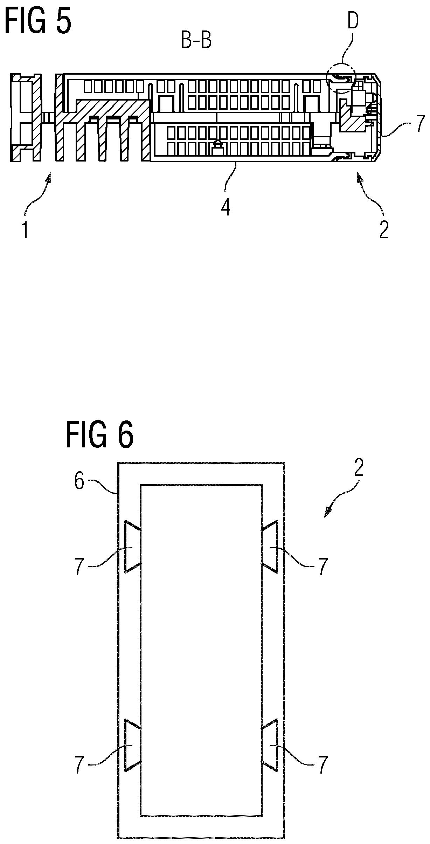

Das zweite Teil 2 weist ebenfalls einen Basiskörper 6 auf, nachfolgend als zweiter Basiskörper 6 bezeichnet. In dem zweiten Basiskörper 6 ist gemäß FIG 6 eine Anzahl von Aufnahmen 7 angeordnet.

Um das erste und das zweite Teil 1, 2 miteinander zu verbinden, werden die Vorsprünge 5 in der Einführrichtung x in die Aufnahmen 7 eingeführt. Hierbei ist für jeden Vorsprung 5 jeweils eine Aufnahme 7 vorhanden. Gegebenenfalls können (beispielsweise aus Gründen der Kompatibilität mit andersartigen ersten Teilen 1) mehr Aufnahmen 7 als Vorsprünge 5 vorhanden sein. In diesem Fall sind die überzähligen Aufnahmen 7 ungenutzt. Mit dem vollständigen Einführen der Vorsprünge 5 in die Aufnahmen 7 verrasten die beiden Teile 1, 2 miteinander und sind dadurch miteinander verbunden.

Nachstehend wird zunächst auf die Gestaltung der Vorsprünge 5 und der Aufnahmen 7 eingegangen, soweit es das Einführen der Vorsprünge 5 in die Aufnahmen 7 geht. Auf die Verrastung wird später eingegangen. Hierbei werden nachstehend nur ein einzelner der Vorsprünge 5 und die zugehörige Aufnahme 7 erläutert. Für die anderen Vorsprünge 5 und die entsprechenden Aufnahmen 7 gelten analoge Ausführungen. Weiterhin wird ein Koordinatensystem mit den Richtungen x, y und z eingeführt. Das Koordinatensystem ist ein rechtständiges kartesisches Koordinatensystem. Die Richtung x ist, wie bereits definiert, die Einführrichtung x. Die Richtungen y und z sind orthogonal zur Einführrichtung x und auch orthogonal zueinander. Sie werden nachstehend als erste und zweite Querrichtung y, z bezeichnet. Die beiden Querrichtungen y, z sind auf den jeweiligen Vorsprung 5 und die jeweilige Aufnahme 7 bezogen. Sie können also bei einem anderen Vorsprung 5 und einer anderen Aufnahme 7 andere Richtungen aufweisen. Da die Einführrichtung x jedoch einheitlich für alle Vorsprünge 5 und Aufnahmen 7 ist, definieren die beiden Querrichtungen y, z stets dieselbe Querebene.

Als allgemeines Prinzip gilt, dass der Vorsprung 5 und die Aufnahme 7 derart aufeinander abgestimmt sind,
- dass der Vorsprung 5 zu Beginn des Einführens des Vorsprungs 5 in die Aufnahmen 7 in den Aufnahmen 7 sowohl in der ersten Querrichtung x als auch in der zweiten Querrichtung y ein Spiel aufweist,
- dass das Spiel beim Einführen des Vorsprungs 5 in die Aufnahme 7 allmählich abnimmt und
- dass das Spiel spätestens dann, wenn der Vorsprung 5 vollständig in die Aufnahme 7 eingeführt ist, den Wert null annimmt.

Das Spiel nimmt also beim Einführen des Vorsprungs 5 in die Aufnahme 8 allmählich von einem Anfangswert, der in beiden Querrichtungen y, z größer als null ist, nach und nach auf Null ab.

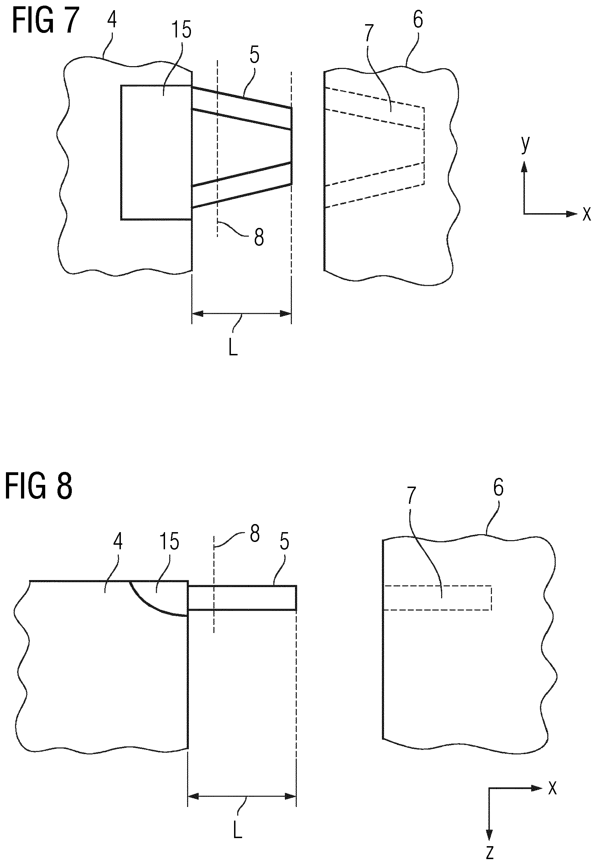

Der Vorsprung 5 erstreckt sich in der Einführrichtung x gesehen über eine Länge L (siehe die FIG 7 und 8). Vorzugsweise sind der Vorsprung 5 und die Aufnahme 8 sogar derart aufeinander abgestimmt, dass das Spiel beim Einführen des Vorsprungs 5 in Aufnahme 7 im wesentlichen über die gesamte Länge L des Vorsprungs 5 gleichzeitig den Wert Null annimmt.

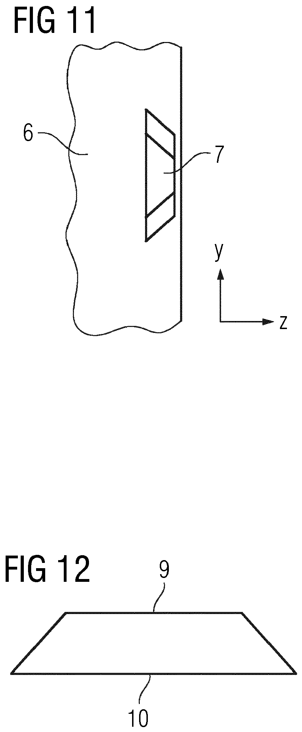

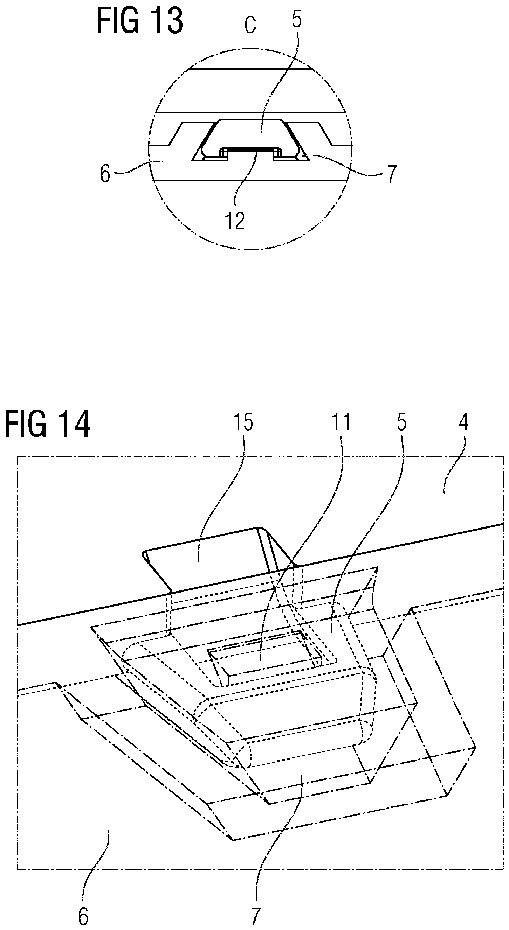

Für die Realisierung einer derartigen Ausgestaltung sind viele Möglichkeiten gegeben. Bevorzugt ist eine Gestaltung, bei der entsprechend der Darstellung in den FIG 7 bis 12 der Vorsprung 5 in der durch die beiden Querrichtungen y und z definierten Querebene gesehen die Kontur eines symmetrischen Trapezes aufweist. Mit dem Bezugszeichen 8 ist in den FIG 7 und 8 eine Linie bezeichnet, entlang derer ein (gedanklich unendlich dünner) Streifen aus dem Vorsprung 5 "herausgeschnitten" ist. Der Streifen ist in FIG 12 dargestellt. Insbesondere FIG 12 zeigt besonders deutlich die Form des Trapezes. FIG 13 zeigt den konkreten Schnitt für die konkrete Ausgestaltung der Baugruppe der FIG 1 bis 5.

Das Trapez weist eine lange Seite 8 und eine kurze Seite 9 auf. Die lange und die kurze Seite 8, 9 verlaufen in der ersten Querrichtung y. Aufgrund der allmählichen Verjüngung des Vorsprungs 5 verringert sich der Querschnitt jedoch nach vorne zu immer weiter. Die Verjüngung kann insbesondere linear erfolgen. Die jeweilige Aufnahme 7 ist passend zum zugehörigen Vorsprung 5 ausgebildet.

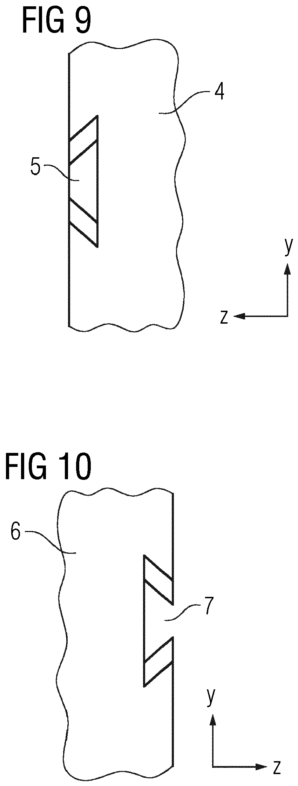

Durch die Verwendung der Kontur eines symmetrischen Trapezes ist es möglich, dass die Aufnahme 7 im Bereich der kurzen Seite 9 des Trapezes offen ist (FIG 10) oder zumindest dünnwandiger als im Bereich der langen Seite des Trapezes ist (FIG 11).

Nunmehr wird auf die Gestaltung der Vorsprünge 5 und der Aufnahmen 7 eingegangen, soweit es das Verrasten der Vorsprünge 5 in den Aufnahmen 7 geht.

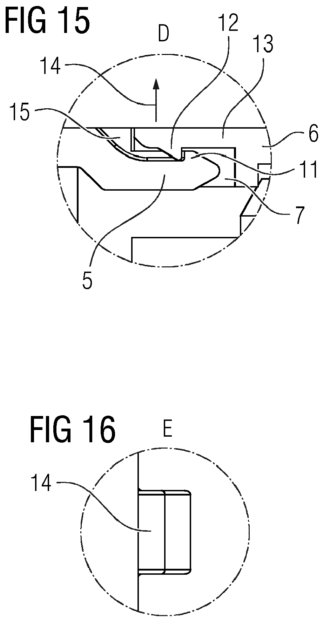

Gemäß FIG 2 - siehe hierzu auch FIG 14 - sind an den Vorsprüngen 5 Rasthaken 11 angeordnet. Hiermit korrespondierend sind - siehe insbesondere FIG 15 - am zweiten Teil 2 im Bereich der Aufnahmen 7 Rastnasen 12 angeordnet. Wenn die Vorsprünge 5 vollständig in die Aufnahmen 7 eingeführt sind, bilden die Rasthaken 11 und die Rastnasen 12 jeweils eine Rastverbindung. Die Rasthaken 11 sind gemäß FIG 14 ersichtlich im Bereich der langen Seiten 10 der Trapeze angeordnet, und zwar innerhalb des durch die Trapeze umschriebenen Volumens. Dies gilt bei der konkreten Ausgestaltung sowohl dann, wenn das erste und das zweite Teil 1, 2 voneinander gelöst sind, als auch dann, wenn das erste und das zweite Teil 1, 2 miteinander verbunden sind. Im Ergebnis ist die entsprechende Anordnung des Rasthakens 11 auch aus FIG 13 erkennbar, weil dort innerhalb des durch die Trapeze umschriebenen Volumens die Rastnase 12 erkennbar ist. Auch FIG 15 zeigt diesen Sachverhalt.

Die Rastnase 12 ist gemäß FIG 15 federelastisch am zweiten Basiskörper 2 angeordnet. Insbesondere ist die Rastnase 12 über einen relativ schmalen Steg 13 mit dem zweiten Basiskörper 6 verbunden, so dass der Steg 13 sich während des Verbindungsvorgangs der beiden Teile 1, 2 miteinander leicht anhebt. Das Abheben ist in FIG 15 durch einen Pfeil 14 angedeutet.

Zum Lösen der jeweiligen Rastverbindung weist das erste Teil 1 in einem Übergangsbereich von dem jeweiligen Vorsprung 5 zum ersten Basiskörper 4 eine Mulde 15 auf, siehe die FIG 1 bis 3, 7, 8 und 14 bis 16. Über die Mulde 15 ist ein Biegen des jeweiligen Rasthakens 11 und/oder der jeweiligen Rastnase 12 und dadurch ein Lösen der jeweiligen Rastverbindung möglich. Insbesondere kann im Bereich der Mulde 15 ein üblicher Schraubendreher angesetzt werden.

Zusammengefasst betrifft die vorliegende Erfindung somit folgenden Sachverhalt:
Ein Erzeugnis weist ein erstes und ein zweites Teil 1, 2 auf, die durch Verrasten miteinander verbunden sind. Das erste Teil 1 weist einen ersten Basiskörper 4 auf, von dem ausgehend sich eine Anzahl von Vorsprüngen 5 erstreckt, so dass die Vorsprünge 5 eine Einführrichtung x definieren. Das zweite Teil 2 weist einen zweiten Basiskörper 6 auf, in dem eine Anzahl von Aufnahmen 7 angeordnet ist. Wenn das erste Teil 1 mit dem zweiten Teil 2 verrastet ist, ist je einer der Vorsprünge 5 des ersten Teils 1 in der Einführrichtung x in je eine der Aufnahmen 7 des zweiten Teils 2 eingeführt. An den Vorsprüngen 5 sind Rasthaken 11 angeordnet, am zweiten Teil 2 im Bereich der Aufnahmen 7 Rastnasen 12. Wenn die Vorsprünge 5 vollständig in die Aufnahmen 7 eingeführt sind, bilden die Rasthaken 11 und die Rastnasen 12 jeweils eine Rastverbindung. Die Vorsprünge 5 und die Aufnahmen 7 sind derart aufeinander abgestimmt, dass die Vorsprünge 5 zu Beginn des Einführens der Vorsprünge 5 in die Aufnahmen 7 in den Aufnahmen 7 in einer orthogonal zur Einführrichtung x verlaufenden Querebene gesehen in zwei zueinander orthogonalen Querrichtungen y, z ein Spiel aufweisen. Das Spiel nimmt beim Einführen der Vorsprünge 5 in die Aufnahmen 7, ausgehend von einem Anfangswert größer als Null, allmählich auf Null ab.

Die vorliegende Erfindung weist viele Vorteile auf. Besondere realisieren die Vorsprünge 5 der vorliegenden Erfindung im Zusammenwirken mit den Aufnahmen 7 sowohl eine Positionierhilfe als auch eine Führung als auch eine Halte- und Rastfunktion. Dadurch, dass die Vorsprünge 5 und die Aufnahmen 7 alle drei Aufgaben gleichzeitig erfüllen, ergibt sich eine platzsparende Gestaltung, die eine exakte Bauteilführung beim Fügen realisiert. Über die Mulden 15 ist eine schnelle und einfache Entriegelung der Verrastungen möglich. Die Rastverbindungen sind im verbundenen Zustand nahezu unsichtbar. Sowohl die Vorsprünge 5 als auch die Aufnahmen 7 können stabil ausgelegt werden, so dass sie sich beim Fügen insbesondere nicht deformieren. Weitergehende Verrastungen oder auch Schraubverbindungen sind nicht erforderlich.

Obwohl die Erfindung im Detail durch das bevorzugte Ausführungsbeispiel näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen.

## Patentansprüche

1. Erzeugnis,
- wobei das Erzeugnis ein erstes und ein zweites Teil (1, 2) aufweist, die durch Verrasten miteinander verbunden sind,
- wobei das erste Teil (1) einen ersten Basiskörper (4) aufweist, von dem ausgehend sich eine Anzahl von Vorsprüngen (5) erstreckt, so dass die Vorsprünge (5) eine Einführrichtung (x) definieren,
- wobei das zweite Teil (2) einen zweiten Basiskörper (6) aufweist, in dem eine Anzahl von Aufnahmen (7) angeordnet ist,
- wobei, wenn das erste Teil (1) mit dem zweiten Teil (2) verrastet ist, je einer der Vorsprünge (5) des ersten Teils (1) in der Einführrichtung (x) in je eine der Aufnahmen (7) des zweiten Teils (2) eingeführt ist,
- wobei an den Vorsprüngen (5) Rasthaken (11) angeordnet sind und am zweiten Teil (2) im Bereich der Aufnahmen (7) Rastnasen (12) angeordnet sind,
- wobei, wenn die Vorsprünge (5) vollständig in die Aufnahmen (7) eingeführt sind, die Rasthaken (11) und die Rastnasen (12) jeweils eine Rastverbindung bilden,
**dadurch gekennzeichnet ,**
**dass** die Vorsprünge (5) und die Aufnahmen (7) derart aufeinander abgestimmt sind, dass die Vorsprünge (5) zu Beginn des Einführens der Vorsprünge (5) in die Aufnahmen (7) in den Aufnahmen (7) in einer orthogonal zur Einführrichtung (x) verlaufenden Querebene gesehen sowohl in einer ersten Querrichtung (y) als auch in einer zur ersten Querrichtung (y) orthogonalen zweiten Querrichtung (z) ein Spiel aufweisen, das beim Einführen der Vorsprünge (5) in die Aufnahmen (7), ausgehend von einem Anfangswert größer als Null, allmählich auf Null abnimmt.

2. Erzeugnis nach Anspruch 1,
**dadurch gekennzeichnet ,**
**dass** die Vorsprünge (5) sich in der Einführrichtung (x) gesehen über eine Länge (L) erstrecken und dass die Vorsprünge (5) und die Aufnahmen (7) derart aufeinander abgestimmt sind, dass das Spiel beim Einführen der Vorsprünge (5) in die Aufnahmen (7) im wesentlichen über die gesamte Länge (L) der Vorsprünge (5) gleichzeitig den Wert Null annimmt.

3. Erzeugnis nach Anspruch 1 oder 2,
**dadurch gekennzeichnet ,**
**dass** die Vorsprünge (5) und die Aufnahmen (7) in der Querebene gesehen die Kontur symmetrischer Trapeze mit einer jeweiligen langen Seite (10) und einer jeweiligen kurzen Seite (9) aufweisen und dass die langen und die kurzen Seiten (10, 9) in der ersten Querrichtung (y) verlaufen.

4. Erzeugnis nach Anspruch 3,
**dadurch gekennzeichnet ,**
**dass** die Aufnahmen (7) im Bereich der kurzen Seiten (9) der Trapeze offen sind oder dünnwandiger als im Bereich der langen Seiten (10) der Trapeze sind.

5. Erzeugnis nach Anspruch 3 oder 4,
**dadurch gekennzeichnet ,**
**dass** die Rasthaken (11) im Bereich der langen Seiten (10) der Trapeze angeordnet sind.

6. Erzeugnis nach Anspruch 3, 4 oder 5,
**dadurch gekennzeichnet ,**
**dass** die Rasthaken (11), wenn das erste und das zweite Teil (1, 2) voneinander gelöst sind, innerhalb der durch die Trapeze umschriebenen Volumina angeordnet sind und die Rastnasen (12) federelastisch am zweiten Basiskörper (6) angeordnet sind.

7. Erzeugnis nach einem der obigen Ansprüche,
**dadurch gekennzeichnet ,**
**dass** das erste Teil (1) in Übergangsbereichen von den Vorsprüngen (5) zum ersten Basiskörper (4) Mulden (15) aufweist, über welche ein Biegen der Rasthaken (11) und/oder der Rastnasen (12) und dadurch ein Lösen der jeweiligen Rastverbindung möglich ist.
